(19) Europäisches Patentamt / European Patent Office / Office européen des brevets

(11) **EP 3 317 915 B1**

(12) **EUROPÄISCHE PATENTSCHRIFT**

(45) Veröffentlichungstag und Bekanntmachung des Hinweises auf die Patenterteilung:
**05.08.2020 Patentblatt 2020/32**

(21) Anmeldenummer: **16740971.3**

(22) Anmeldetag: **30.06.2016**

(51) Int Cl.:
**H01P 5/16** (2006.01) **H03H 7/48** (2006.01)

(86) Internationale Anmeldenummer:
**PCT/EP2016/065377**

(87) Internationale Veröffentlichungsnummer:
**WO 2017/001595 (05.01.2017 Gazette 2017/01)**

(54) **LEISTUNGSCOMBINER ZUR KOPPLUNG VON HOCHFREQUENZSIGNALEN UND LEISTUNGSCOMBINERANORDNUNG MIT EINEM SOLCHEN LEISTUNGSCOMBINER**

POWER COMBINER FOR COUPLING HIGH-FREQUENCY SIGNALS AND POWER COMBINER ARRANGEMENT COMPRISING A POWER COMBINER OF THIS TYPE

COUPLEUR DE PUISSANCE POUR COUPLER DES SIGNAUX HAUTE FRÉQUENCE ET ENSEMBLE COUPLEUR DE PUISSANCE COMPRENANT CE COUPLEUR DE PUISSANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.06.2015 DE 102015212232**

(43) Veröffentlichungstag der Anmeldung:
**09.05.2018 Patentblatt 2018/19**

(73) Patentinhaber: **TRUMPF Hüttinger GmbH + Co. KG 79111 Freiburg im Breisgau (DE)**

(72) Erfinder:
- **GREDE, André**
  **3018 Bern (CH)**
- **ALT, Alexander**
  **Cardiff CF143UA (GB)**
- **GRUNER, Daniel**
  **79379 Muellheim (DE)**
- **LABANC, Anton**
  **79238 Ehrenkirchen (DE)**

(74) Vertreter: **Trumpf Patentabteilung Trumpf GmbH & Co KG TH501 Patente und Lizenzen Johann-Maus-Straße 2 71254 Ditzingen (DE)**

(56) Entgegenhaltungen:
EP-A2- 0 911 904    DE-A1-102010 002 754
DE-A1-102012 200 634    DE-T5-112008 000 120
US-B2- 6 967 544

- **ERCOLI M ET AL: "An extremely miniaturized ultra wide band 10 67 GHz Power Splitter in 65 nm CMOS Technology", MICROWAVE SYMPOSIUM DIGEST (MTT), 2012 IEEE MTT-S INTERNATIONAL, IEEE, 17. Juni 2012 (2012-06-17), Seiten 1-3, XP032216988, DOI: 10.1109/MWSYM.2012.6259472 ISBN: 978-1-4673-1085-7**
- **JEONG-GEUN KIM ET AL: "Miniature Four-Way and Two-Way 24 GHz Wilkinson Power Dividers in 0.13 m CMOS", IEEE MICROWAVE AND WIRELESS COMPONENTS LETTERS, IEEE SERVICE CENTER, NEW YORK, NY, US, Bd. 17, Nr. 9, 1. September 2007 (2007-09-01), Seiten 658-660, XP011191220, ISSN: 1531-1309, DOI: 10.1109/LMWC.2007.903451**
- **SEYED MAJID MOHAMADI DEMNEH ET AL: "A lumped-element power divider/combiner suitable for high power applications", MICROWAVE AND MILLIMETER WAVE TECHNOLOGY (ICMMT), 2012 INTERNATIONAL CONFERENCE ON, IEEE, 5. Mai 2012 (2012-05-05), Seiten 1-4, XP032451825, DOI: 10.1109/ICMMT.2012.6229943 ISBN: 978-1-4673-2184-6**

EP 3 317 915 B1

**Beschreibung**

Die Erfindung betrifft einen Leistungscombiner zur Kopplung von Hochfrequenzsignalen mit einer Frequenz von mehr als 1 MHz zu einer Ausgangsleistung von mehr als 100 W. Die Erfindung betrifft weiterhin eine Leistungscombineranordnung mit einem solchen Leistungscombiner.

Leistungscombiner sind beispielsweise aus den folgenden Schriften bekannt: EP 0 210 606 A2, DE 27 33 888 A1, US 2014/0292441 A1, EP 1 347 532 A1.

In [Ercoli M. et al.: "An extremely miniaturized ultra wide band 10-67 GHz Power Splitter in 65 nm CMOS Technology", microwave symposium digest (MTT), 2012 IEEE MTT-S international, IEEE, 17. Juni 2012, Seiten 1-3] und in [Jeong-Geun Kim et al: "Miniature Four-Way and Two-Way 24 GHz Wilkinson Power Dividers in 0.13 m CMOS", IEEE microwave and wireless components letters, IEEE service center, New York, NY, US, Bd. 17, Nr. 9, 1. Sept. 2007, Seiten 658-660] werden jeweils miniaturisierte modifizierte Wilkinson Splitter / Kombinierer mit Abmessungen kleiner 1 mm$^2$ für kleine Leistungen und mit konzentrierten Bauteilen offenbart.

In [Seyed Majid Mohamadi Demneh et al: "A lumped element power divider/combiner suitable for high power applications", microwave and millimeter wave technology (ICMMT), 2012 international conference on, IEEE, 5. Mai 2012, Seiten 1-4] wird ein modifizierter Wilkinson Splitter/Kombinierer mit konzentrierten Bauteilen offenbart, der auf einer Leiterkarte aufgebaut ist und ausgelegt ist für 150 MHz und bis zu 56,7 W Leistung.

Die Ausgangsleistung von Hochfrequenzsignalquellen, insbesondere von HF-Transistorverstärkern, ist auf einige 100 W bis wenige kW beschränkt. Um eine höhere Ausgangsleistung zu erzielen, müssen daher mehrere Hochfrequenzsignalquellen mittels eines Leistungscombiners zusammengeschaltet werden. Die Leistungscombiner sollen bei großer Bandbreite möglichst kleine Verluste aufweisen.

Gleichzeitig sollen jedoch die Eingänge des Leistungscombiners, an denen die Hochfrequenzsignalquellen anschließbar sind, möglichst gut voneinander isoliert sein, um eine Querspeisung der Hochfrequenzsignalquellen und eine ungleichmäßige Verteilung reflektierter Ausgangsleistung zu vermeiden. Bei ungleichen Amplituden, Phasen oder Innenimpedanzen der an den Leistungscombiner angeschlossenen Hochfrequenzsignalquellen entsteht nämlich ein für die Hochfrequenzsignalquellen schädliches Gegentaktsignal. Zusätzlich oder alternativ dazu können sich bei ungleicher Aufteilung der reflektierten Leistung die Phasen und/oder Amplitude sowie die Lastimpedanz der Einzelverstärker ändern. Das kann zu übermäßiger Beanspruchung des am stärksten belasteten Verstärker führen.

Aus dem Stand der Technik ist es bekannt geworden, die an den Eingängen eines Leistungscombiners angeschlossenen Hochfrequenzsignalquellen bei gleich bleibenden Frequenzen der Hochfrequenzsignalquellen zu schützen. Zur Anpassung an eine Last, die an einen Ausgang des Leistungscombiners anschließbar ist, sollten die an den Eingängen des Leistungscombiners angeschlossenen Hochfrequenzsignalquellen jedoch mit variabler Frequenz (sogenannter Frequency-Tuning-Betrieb) betrieben werden. Es ist daher wünschenswert, einen Leistungscombiner bereit zu stellen, dessen Eingänge auch bei Frequenzänderungen, für den Fall von ungleichen Amplituden, Phasen oder Innenimpedanzen von an den Eingängen angeschlossenen Hochfrequenzsignalquellen, signifikant besser angepasst und isoliert sind.

Die Aufgabe der vorliegenden Erfindung ist es daher, einen Leistungscombiner und eine Leistungscombineranordnung mit einem solchen Leistungscombiner zu schaffen, die sicher und stabil im Frequency-Tuning-Betrieb arbeiten.

Diese Aufgabe wird durch einen Leistungscombiner mit den Merkmalen des Patentanspruchs 1 und einer Leistungscombineranordnung mit den Merkmalen des Patentanspruchs 14 gelöst. Die abhängigen Patentansprüche geben bevorzugte Weiterbildungen an.

Die erfindungsgemäße Aufgabe wird somit gelöst durch Leistungscombiner zur Kopplung von Hochfrequenzsignalen mit einer Frequenz von mehr als 1 MHz zu einer Ausgangsleistung von mehr als 100 W, wobei der Leistungscombiner Folgendes aufweist:

    a) einen ersten Eingang für ein erstes Hochfrequenzsignal;
    b) einen zweiten Eingang für ein zweites Hochfrequenzsignal;
    c) einen Ausgang zum Anschluss eines Verbrauchers;
    d) einen Erdungsanschluss;
    e) eine erste Induktivität, die den ersten Eingang mit dem Ausgang verbindet;
    f) eine zweite Induktivität, die den zweiten Eingang mit dem Ausgang verbindet;
    g) einen Combinerkondensator, der den Ausgang mit dem Erdungsanschluss verbindet;

wobei die erste Induktivität magnetisch von der zweiten Induktivität entkoppelt ist und wobei der erste Eingang über ein RC-Anpassungsglied des Leistungscombiners mit dem zweiten Eingang verbunden ist. Der Leistungscombiner ist zur Kopplung von Hochfrequenzsignalen zwischen 1 MHz und 200 MHz ausgebildet. Die Induktivitäten sind als planare Induktivitäten in parallelen oder in einer gleichen Ebene beabstandet voneinander angeordnet. Die äußersten Windungen solcher beabstandeter planarer Induktivitäten weisen einen Abstand von wenigstens 1 cm auf.

Dabei kann der Leistungscombiner zumindest teilweise planar durch eine Multilayerleiterkarte ausgebildet sein.

Ferner kann der Leistungscombiner eine erste Leiterplatte mit einer ersten elektrisch leitfähigen Lage und einer ersten elektrisch isolierenden Schicht aufweisen.

Ferner kann die erste Leiterplatte ein RC-Anpassungsglied aufweisen.

Der erfindungsgemäße Leistungscombiner weist somit einen LC-Kombinierer aus Induktivitäten und einem gemeinsamen Combinerkondensator auf, wobei die Induktivitäten magnetisch voneinander entkoppelt sind.

Die Entkopplung der beiden Induktivitäten schließt eine nur geringfügige parasitäre Kopplung nicht aus. Ziel ist jedoch eine möglichst geringe Kopplung. Dazu können wie oben erwähnt die Induktivitäten als planare Induktivitäten in parallelen oder in einer gleichen Ebene beabstandet voneinander angeordnet sein. Die äußersten Windungen solcher beabstandeter planarer Induktivitäten können einen Abstand von wenigstens 1 cm aufweisen.

Erfindungsgemäß ist dabei ein Anpassungsnetzwerk zwischen den Eingängen des Leistungscombiners vorgesehen, das eine resistivkapazitive Schaltungsanordnung, nämlich das RC-Anpassungsglied, aufweist. Die Dimensionierung des RC-Anpassungsglieds erfolgt auf Grundlage einer Grundfrequenz, mit der der Leistungscombiner betrieben wird. Der Leistungscombiner ermöglicht im Ergebnis geringe Verluste bei kleiner Baugröße und hohen Bandbreiten.

Besonders bevorzugt ist der Leistungscombiner zur Ausgabe von Leistungen über 2 kW ausgebildet.

In besonders bevorzugter Ausgestaltung des Leistungscombiners ist der Leistungscombiner zu einer Durchgangsdämpfung von weniger als 0,5 dB, insbesondere von weniger als 0,1 dB, weiter bevorzugt von weniger als 0,05 dB ausgebildet. Dies insbesondere beim Betrieb bei einer Frequenz von $\pm 10$ % der Grundfrequenz.

Der Leistungscombiner kann als Leistungssplitter betrieben werden.

Der Leistungscombiner weist vorzugsweise einen dritten Eingang für ein drittes Hochfrequenzsignal auf, wobei der dritte Eingang über eine dritte Induktivität des Leistungscombiners mit dem Ausgang verbunden ist, wobei die dritte Induktivität magnetisch von der ersten Induktivität und der zweiten Induktivität entkoppelt ist, wobei ein erstes RC-Anpassungsglied einenends mit dem ersten Eingang verbunden ist, wobei ein zweites RC-Anpassungsglied einenends mit dem zweiten Eingang verbunden ist und wobei ein drittes RC-Anpassungsglied einenends mit dem dritten Eingang verbunden ist, wobei das erste RC-Anpassungsglied, das zweite RC-Anpassungsglied und das dritte RC-Anpassungsglied anderenends miteinander verbunden sind.

In dieser Ausgestaltung der Erfindung sind drei Hochfrequenzsignalquellen an jeweils einem Eingang des Leistungscombiners anschließbar. Der erste Eingang ist über das erste RC-Anpassungsglied und das zweite RC-Anpassungsglied mit dem zweiten Eingang verbunden. Der zweite Eingang ist über das zweite RC-Anpassungsglied und das dritte RC-Anpassungsglied mit dem dritten Eingang verbunden. Der dritte Eingang ist über das dritte RC-Anpassungsglied und das erste RC-Anpassungsglied mit dem ersten Eingang verbunden.

Weiter bevorzugt kann der Leistungscombiner einen weiteren Eingang für ein weiteres Hochfrequenzsignal aufweisen, wobei der weitere Eingang über eine weitere Induktivität des Leistungscombiners mit dem Ausgang verbunden ist, wobei die weitere Induktivität magnetisch von der ersten Induktivität, der zweiten Induktivität und der dritten Induktivität entkoppelt ist und wobei ein weiteres RC-Anpassungsglied einenends mit dem weiteren Eingang und anderenends mit dem ersten RC-Anpassungsglied, dem zweiten RC-Anpassungsglied und dem dritten RC-Anpassungsglied verbunden ist.

Der Leistungscombiner kann beliebig viele weitere Eingänge aufweisen, die über jeweils eine weitere Induktivität mit dem Ausgang verbunden sind, wobei die weiteren Induktivitäten magnetisch von den übrigen Induktivitäten entkoppelt sind, wobei die weiteren Eingänge jeweils mit einem weiteren RC-Anpassungsglied verbunden sind, wobei die weiteren RC-Anpassungsglieder jeweils einenends mit dem weiteren Eingang und anderenends mit den anderen RC-Anpassungsgliedern verbunden sind.

Die Induktivitäten sind vorzugsweise gleich dimensioniert. Besonders bevorzugt sind das erste RC-Anpassungsglied, das zweite RC-Anpassungsglied, das dritte RC-Anpassungsglied und/oder jedes weitere RC-Anpassungsglied gleich dimensioniert.

Weiter bevorzugt sind die RC-Anpassungsglieder so gewählt, dass die Gesamtimpedanz zwischen jeweils zwei Eingängen 100 $\Omega$ beträgt. Hierdurch können handelsübliche, einen Ausgangswiderstand von 50 $\Omega$ aufweisende Hochfrequenzsignalquellen mit dem Leistungscombiner effektiv und sicher zusammengeschaltet werden.

Die RC-Anpassungsglieder sind zur Vereinfachung der Schaltung und Erleichterung der Fertigung des Leistungscombiners an einem Ende in einem Kreuzungspunkt verschaltet. Der Kreuzungspunkt ist vorzugsweise sternförmig ausgebildet.

Ein RC-Anpassungsglied kann eine Reihenschaltung aus einem Anpassungswiderstand und einem Anpassungskondensator aufweisen. Eine solche Reihenschaltung ist konstruktiv besonders einfach ausgebildet, leicht berechen- und dimensionierbar sowie kostengünstig fertigbar.

Das RC-Anpassungsglied ist vorzugsweise in Form einer Reihenschaltung aus einem Anpassungswiderstand und einem Anpassungskondensator ausgebildet.

Vorzugsweise weisen mehrere RC-Anpassungsglieder jeweils eine Reihenschaltung aus einem Anpassungswiderstand und einem Anpassungskondensator auf oder sind jeweils aus einer Reihenschaltung aus einem Anpassungswiderstand und einem Anpassungskondensator ausgebildet.

In weiter bevorzugter Ausgestaltung der Erfindung weisen alle RC-Anpassungsglieder eine Reihenschaltung aus einem Anpassungswiderstand und einem Anpassungskondensator auf oder sind - weiter bevorzugt - jeweils in Form einer Reihenschaltung aus einem Anpassungswiderstand und einem Anpassungskondensator ausgebildet.

Die Fertigung des Leistungscombiners wird weiter vereinfacht und der für den Leistungscombiner benötigte Bauraum weiter reduziert, wenn der Leistungscombiner zumindest teilweise planar in Form einer Mehrlagenleiterkarte (Multilayerleiterkarte) ausgebildet ist, wobei der Leistungscombiner eine erste Leiterplatte aufweist. Die erste Leiterplatte weist eine erste elektrisch leitfähige Lage und eine erste elektrisch isolierende Schicht auf. Die erste elektrisch leitfähige Lage ist an der ersten elektrisch isolierenden Schicht angeordnet. Die Multilayerleiterkarte weist mehrere elektrisch leitfähige Lagen auf, die zueinander insbesondere parallel angeordnet sind.

Vorzugsweise sind mehrere, insbesondere alle, elektrisch leitfähigen Lagen der Multilayerleiterkarte nicht durch Luft, sondern durch ein Dielektrikum, insbesondere eine elektrisch isolierende Schicht, von der jeweils benachbarten elektrisch leitfähigen Lage getrennt, um Bauraum zu sparen und die Durchschlagsfestigkeit des Leistungscombiners zu erhöhen.

Der Leistungscombiner kann dadurch gekennzeichnet sein, dass die erste Leiterplatte ein RC-Anpassungsglied aufweist. Die erste Leiterplatte ist dabei vorzugsweise von außen zugänglich am Leistungscombiner angeordnet. Hierdurch kann das RC-Anpassungsglied leicht eingestellt werden.

Vorzugsweise weist die erste Leiterplatte mehrere, insbesondere alle, RC-Anpassungsglieder auf.

Die RC-Anpassungsglieder sind auf der ersten Leiterplatte vorzugsweise in dem Kreuzungspunkt verbunden. Besonders bevorzugt ist die erste Leiterplatte axialsymmetrisch zu einer Achse ausgebildet, die senkrecht zu der Hauptebene der ersten Leiterplatte verläuft und den Kreuzungspunkt schneidet.

Ein Anpassungswiderstand und ein Anpassungskondensator eines RC-Anpassungsgliedes können jeweils in Bauteilform auf die erste Leiterplatte bestückt sein. Das RC-Anpassungsglied kann dadurch nachträglich geändert, beispielsweise ausgetauscht oder anders dimensioniert werden.

Vorzugsweise sind alle Anpassungswiderstände und alle Anpassungskondensatoren der RC-Anpassungsglieder jeweils in Bauteilform auf die erste Leiterplatte bestückt.

Weiter bevorzugt weist die erste Leiterplatte den ersten Eingang und den zweiten Eingang, insbesondere alle Eingänge, auf. Ist die erste Leiterplatte von außen zugänglich, können die Hochfrequenzsignalquellen hierdurch leicht an den Leistungscombiner angeschlossen werden. Die erste Leiterplatte kann den Ausgang und/oder den Erdungsanschluss aufweisen.

Bauraum wird eingespart und die Fertigung des Leistungscombiners vereinfacht, wenn der Combinerkondensator in Form eines Plattenkondensators ausgebildet ist, wobei eine erste Platte des Plattenkondensators auf einer zweiten elektrisch leitfähigen Lage der Multilayerleiterkarte und eine zweite Platte des Plattenkondensators auf einer dritten elektrisch leitfähigen Lage der Multilayerleiterkarte ausgebildet sind.

Der Plattenkondensator kann eine dritte Platte aufweisen, die mit der ersten Platte leitend verbunden ist und auf einer vierten elektrisch leitfähigen Lage der Multilayerleiterkarte ausgebildet ist. Die Kapazität des Combinerkondensators kann dadurch ohne wesentliche Bauraumvergrößerung signifikant erhöht werden.

Besonders bevorzugt ist die zweite Platte des Plattenkondensators zwischen der ersten Platte und der dritten Platte angeordnet.

Weiter bevorzugt ist die zweite Platte mit dem Erdungsanschluss leitend verbunden.

In weiter bevorzugter Ausgestaltung der Erfindung ist der Erdungsanschluss mit einer Kühlplatte des Leistungscombiners verbunden.

Die zweite elektrisch leitfähige Lage weist zur weiteren Einsparung von Bauraum vorzugsweise die erste Induktivität in Form einer planar ausgebildeten Induktivität auf.

Die zweite elektrisch leitfähige Lage kann weiterhin die zweite Induktivität in Form einer planar ausgebildeten Induktivität, die dritte Induktivität in Form einer planar ausgebildeten Induktivität und/oder die vierte Induktivität in Form einer planar ausgebildeten Induktivität aufweisen. Vorzugsweise weist die zweite elektrisch leitfähige Lage alle Induktivitäten auf, wobei die Induktivitäten jeweils in Form planar ausgebildeter Induktivitäten ausgebildet sind.

Die erfindungsgemäße Aufgabe wird weiterhin gelöst durch eine Leistungscombineranordnung mit einem zuvor beschriebenen Leistungscombiner, wobei die Leistungscombineranordnung eine erste Hochfrequenzsignalquelle, die an den ersten Eingang angeschlossen ist, und eine zweite Hochfrequenzsignalquelle, die an den zweiten Eingang angeschlossen ist, sowie insbesondere einen Verbraucher aufweist, der an den Ausgang angeschlossen ist.

Die Leistungscombineranordnung kann eine dritte Hochfrequenzsignalquelle, die an den dritten Eingang angeschlossen ist, und/oder eine vierte Hochfrequenzsignalquelle, die an den vierten Eingang angeschlossen ist, aufweisen. Weiterhin kann die Leistungscombineranordnung weitere Hochfrequenzsignalquellen aufweisen, die an weitere Eingänge angeschlossen sind.

Die erste Hochfrequenzsignalquelle, die zweite Hochfrequenzsignalquelle, die dritte Hochfrequenzsignalquelle, die vierte Hochfrequenzsignalquelle und/oder weitere Hochfrequenzsignalquellen sind vorzugsweise in Form von HF-Transistorverstärkern, insbesondere von frequenzagilen HF-Transistorverstärkern, ausgebildet. Besonders bevorzugt sind alle Hochfrequenzsignalquellen identisch ausgebildet.

Der Verbraucher ist vorzugsweise in Form einer Plasmaanlage ausgebildet.

Die Impedanz der RC-Anpassungsglieder ist vorzugsweise so gewählt, dass die Gesamtimpedanz zwischen zwei Eingängen des Leistungscombiners der Summe der Ausgangsimpedanzen der Hochfrequenzsignalquellen entspricht, die an diesen beiden Eingängen angeschlossen sind. Die Hochfrequenzsignalquellen werden dadurch voneinander isoliert und besonders effektiv vor einem Gegentaktsignal geschützt.

Vorzugsweise weisen die Hochfrequenzsignalquellen jeweils eine Ausgangsimpedanz von 50 Ω auf, wobei die RC-Anpassungsglieder so gewählt sind, dass die Gesamtimpedanz zwischen zwei Eingängen, an denen die Hochfrequenzsignalquellen angeschlossen sind, 100 Ω beträgt. Die Leistungscombineranordnung ermöglicht hierdurch den Einsatz handelsüblicher Hochfrequenzsignalquellen.

Weitere Merkmale und Vorteile der Erfindung ergeben sich aus der nachfolgenden detaillierten Beschreibung mehrerer Ausführungsbeispiele der Erfindung, anhand der Figuren der Zeichnung, die erfindungswesentliche Einzelheiten zeigt, sowie aus den Patentansprüchen.

Die in der Zeichnung dargestellten Merkmale sind derart dargestellt, dass die erfindungsgemäßen Besonderheiten deutlich sichtbar gemacht werden können. Die verschiedenen Merkmale können je einzeln für sich oder zu mehreren in beliebigen Kombinationen bei Varianten der Erfindung verwirklicht sein.

Es zeigen:

Fig. 1     Ein Schaltbild einer ersten erfindungsgemäßen Leistungscombineranordnung mit einem Leistungscombiner und zwei an dem Leistungscombiner angeschlossenen Hochfrequenzsignalquellen ;

Fig. 2     ein Diagramm zum Vergleich der erfindungsgemäßen Leistungscombineranordnung mit einem Wilkinson-Schaltkreis gemäß dem Stand der Technik;

Fig. 3     ein Schaltbild einer zweiten erfindungsgemäßen Leistungscombineranordnung mit einem weiteren Leistungscombiner und vier an dem Leistungscombiner angeschlossenen Hochfrequenzsignalquellen; und

Fig. 4     eine schematische teilweise Darstellung eines Aufbaus eines weiteren Leistungscombiners.

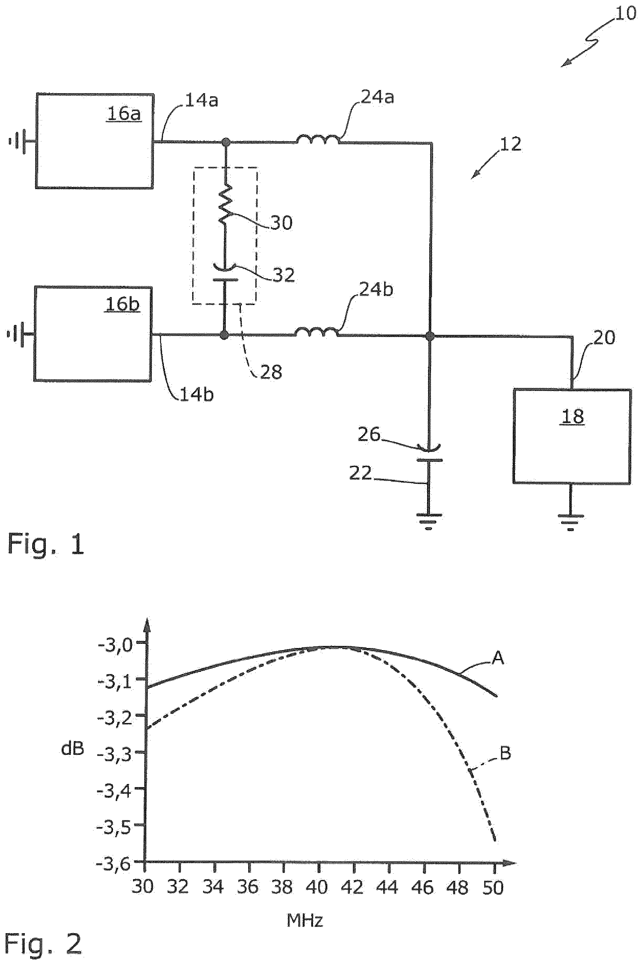

Fig. 1 zeigt eine Leistungscombineranordnung 10 mit einem Leistungscombiner 12. Der Leistungscombiner 12 weist einen ersten Eingang 14a und einen zweiten Eingang 14b auf, an denen jeweils eine Hochfrequenzsignalquelle 16a, 16b angeschlossen ist. Die Hochfrequenzsignalquellen 16a-b dienen der Versorgung eines Verbrauchers 18 in Form einer Plasmaanlage. Der Verbraucher 18 ist an einen Ausgang 20 des Leistungscombiners 12 angeschlossen. Der Leistungscombiner weist weiterhin einen Erdungsanschluss 22 auf.

Die Kopplung der Hochfrequenzsignale der Hochfrequenzsignalquellen 16a-b erfolgt durch Induktivitäten 24a, 24b und einen Combinerkondensator 26.

Zur Isolation der beiden Eingänge 14a-b und zum Schutz der beiden Hochfrequenzsignalquellen 16a-b vor ungleichmäßig aufgeteilten reflektierten Gegentaktsignalen ist zwischen den Eingängen 14a-b ein RC-Anpassungsglied 28 geschaltet, das in Fig. 1 gestrichelt gerahmt ist. Das RC-Anpassungsglied 28 weist einen Anpassungswiderstand 30 und einen Anpassungskondensator 32 auf.

Das RC-Anpassungsglied 28 ist in Form einer Reihenschaltung aus dem Anpassungswiderstand 30 und dem Anpassungskondensator 32 ausgebildet. Das RC-Anpassungsglied 28 ist so dimensioniert, dass die Impedanz zwischen den Eingängen 14a-b der Summe aus den Ausgangsimpedanzen der Hochfrequenzsignalquellen 16a-b entspricht. Im vorliegenden Fall weisen die beiden Hochfrequenzsignalquellen 16a-b jeweils eine Ausgangsimpedanz von 50 Ω auf. Das RC-Anpassungsglied 28 ist somit derart dimensioniert, dass die Impedanz zwischen den Eingängen 14a-b 100 Ω entspricht.

Die Impedanz zwischen den Eingängen 14a-b wird dabei durch das RC-Anpassungsglied 28 und die beiden Induktivitäten 24a-b bestimmt und berechnet sich - basierend auf einer Grundfrequenz - wie folgt:

$$Z = \left(\frac{1}{j\varpi L_1 + j\varpi L_2} + \frac{1}{R_1 - \dfrac{j}{\varpi C}}\right)^{-1} = 100\ \Omega$$

Dabei ist Z die Impedanz zwischen den Eingängen 14a-b, $L_1$ die Induktivität der ersten Induktivität 24a, $L_2$ die Induktivität der zweiten Induktivität 24b, $R_1$ der Widerstand des Anpassungswiderstands 30 und C die Kapazität des Anpassungskondensators 32.

Im Ergebnis weist der Anpassungswiderstand 30 einen Widerstand von 50 $\Omega$, der Anpassungskondensator 32 eine Kapazität von 78 pF, die Induktivitäten 24a-b jeweils eine Induktivität von 195 nH und der Combinerkondensator eine Kapazität von 78 pF auf. Die zuvor genannte Berechnung liefert eine optimale Balance des Leistungscombiners 12 bei Abweichungen von der Grundfrequenz der Hochfrequenzsignalquellen 16ab.

Fig. 2 zeigt einen Vergleich der Bandbreiten eines erfindungsgemäßen ausbalancierten Leistungscombiners (durchgezogene Linie, A) mit einem CLC-Wilkinson-Leistungscombiner gemäß dem Stand der Technik (strichpunktierte Linie, B). Aus Fig. 2 ist ersichtlich, dass der erfindungsgemäße Leistungscombiner bei Abweichen von einer Grundfrequenz, auf die der Leistungscombiner dimensioniert ist, eine signifikant bessere Übertragungscharakteristik aufweist.

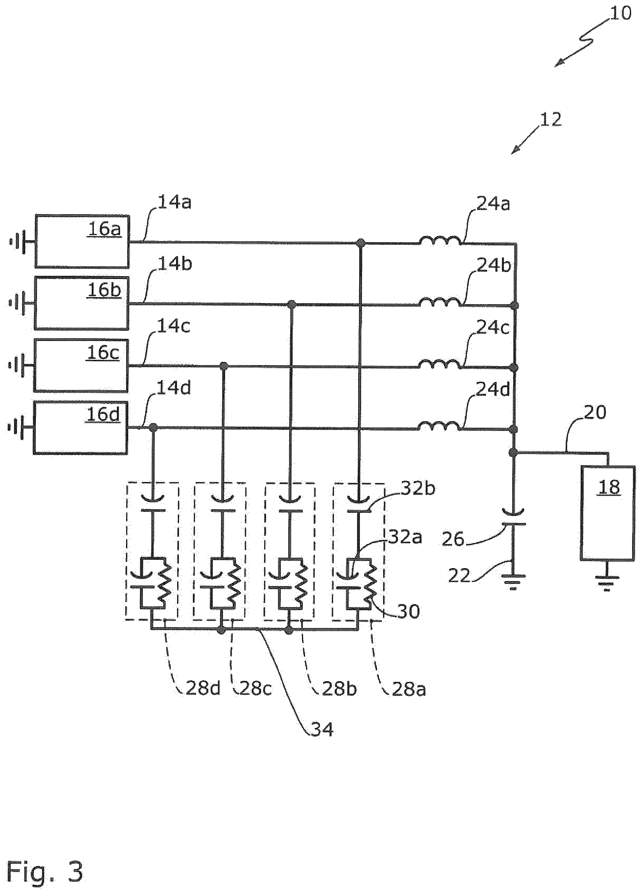

Fig. 3 zeigt eine weitere Leistungscombineranordnung 10 mit einem Leistungscombiner 12. Der Leistungscombiner 12 weist einen ersten Eingang 14a, einen zweiten Eingang 14b, einen dritten Eingang 14c und einen vierten Eingang 14d auf. Eine erste Hochfrequenzsignalquelle 16a ist an den ersten Eingang 14a, eine zweite Hochfrequenzsignalquelle 16b an den zweiten Eingang 14b, eine dritte Hochfrequenzsignalquelle 16c an den dritten Eingang 14c und eine vierte Hochfrequenzsignalquelle 16d an den vierten Eingang 14d angeschlossen.

Eine erste Induktivität 24a ist einenends mit dem ersten Eingang 14a, eine zweite Induktivität 24b ist einenends mit dem zweiten Eingang 14b, eine dritte Induktivität 24c ist einenends mit dem dritten Eingang 14c und eine vierte Induktivität 24d ist einenends mit dem vierten Eingang 14d verbunden. Die Induktivitäten 24a-d sind anderenends mit einem Ausgang 20 verbunden, an den ein Verbraucher 18 angeschlossen ist. Weiterhin sind die Induktivitäten 24a-d anderenends mit einem Combinerkondensator 26 verbunden. Der Combinerkondensator 26 ist mit einem Erdungsanschluss 22 verbunden.

Ein erstes RC-Anpassungsglied 28a ist einenends mit dem ersten Eingang 14a, ein zweites RC-Anpassungsglied 28b ist einenends mit dem zweiten Eingang 14b, ein drittes RC-Anpassungsglied 28c ist einenends mit dem dritten Eingang 14c und ein viertes RC-Anpassungsglied 28d ist einenends mit dem vierten Eingang 14d verbunden. Die RC-Anpassungsglieder 28a-d sind anderenends an einem Kreuzungspunkt 34 miteinander verbunden.

Die RC-Anpassungsglieder 28a-d sind identisch ausgebildet. Nachstehend wird daher zur Vermeidung von Wiederholungen nur auf das erste RC-Anpassungsglied 28a näher eingegangen. Das erste RC-Anpassungsglied 28a weist eine Parallelschaltung aus einem Anpassungswiderstand 30 und einem ersten Anpassungskondensator 32a auf, wobei diese Parallelschaltung mit einem zweiten Anpassungskondensator 32b in Reihe geschaltet ist. Das erste RC-Anpassungsglied 28a ist derart dimensioniert, dass zwischen den Eingängen 14a-b - unter Berücksichtigung des zweiten RC-Anpassungsgliedes 28b und den Induktivitäten 24a-b - eine Impedanz vorliegt, die der Summe der Ausgangsimpedanzen der Hochfrequenzsignalquellen 16a-b entspricht. Hierdurch weist der Kreuzungspunkt 34 virtuell Erdungspotential auf. Im vorliegenden Fall weist das erste RC-Anpassungsglied 28a einen Widerstand von 50 $\Omega$ auf, wobei die Induktivitäten 24a-b jeweils eine Induktivität von 300 nH bis 400 nH, insbesondere 339 nH, aufweisen.

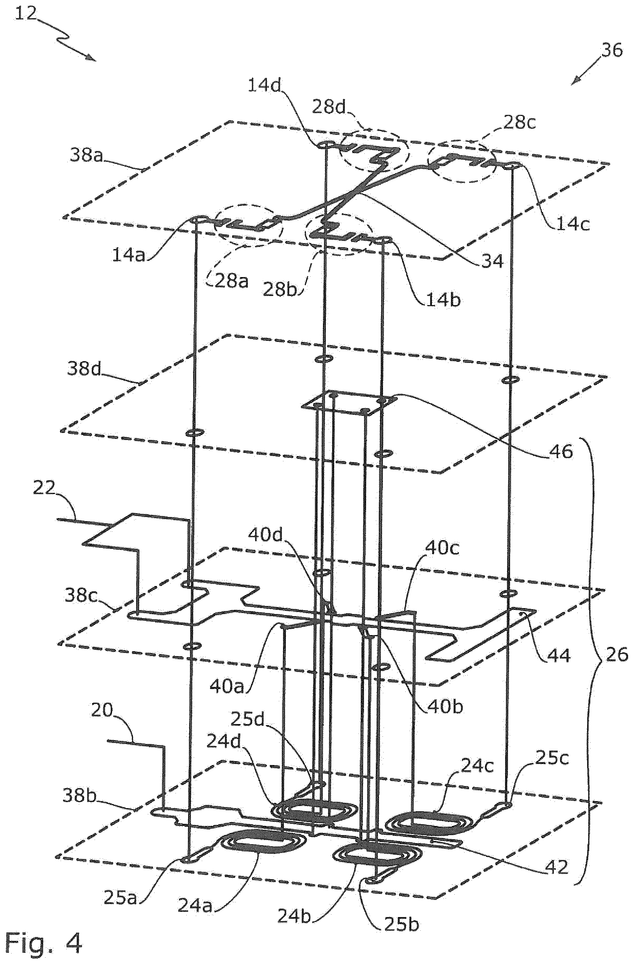

Fig. 4 zeigt einen schematischen Aufbau eines weiteren Leistungscombiners 12. Der Leistungscombiner 12 weist eine Multilayerleiterkarte 36 auf. Die Multilayerleiterkarte 36 weist mehrere elektrisch leitfähige Lagen auf. Im vorliegenden Fall weist die Multilayerleiterkarte 36 eine erste elektrisch leitfähige Lage 38a, eine zweite elektrisch leitfähige Lage 38b, eine dritte elektrisch leitfähige Lage 38c und eine vierte elektrisch leitfähige Lage 38d auf.

Die elektrisch leitfähigen Lagen 38a-d sind aus Gründen der Übersichtlichkeit überproportional weit voneinander entfernt dargestellt. In Fig. 4 sind weiterhin aus Gründen der Übersichtlichkeit nicht die elektrisch leitfähigen Strukturen der elektrisch leitfähigen Lagen 38a-d mit einem Bezugszeichen versehen, sondern Ebenen, in denen sich die elektrisch leitfähigen Strukturen der elektrisch leitfähigen Lagen 38a-d befinden. Zwischen den elektrisch leitfähigen Lagen 38a-d weist die Multilayerleiterkarte 36 elektrisch isolierende Schichten auf, die aus Gründen der Übersichtlichkeit in Fig. 4 nicht dargestellt sind.

Eingänge 14a-d befinden sich in der obersten, von außen zugänglichen ersten elektrisch leitfähigen Lage 38a. Die Eingänge 14a-d sind jeweils mit gestrichelt eingerahmten RC-Anpassungsgliedern 28a-d verbunden. Die RC-Anpassungsglieder 28a-d weisen jeweils Aufnahmen für Anpassungswiderstände und Anpassungskondensatoren auf, die in Fig. 4 aus Gründen der Darstellbarkeit lediglich angedeutet sind.

Die den Eingängen 14a-d abgewandten Enden der RC-Anpassungsglieder 28a-d sind an einem Kreuzungspunkt 34 zusammengeführt. Durch die punktförmige Ausbildung der Zusammenführung am Kreuzungspunkt 34 weist der Kreuzungspunkt 34 vorteilhafterweise eine gute Symmetrie auf. Die kapazitive Wirkung kann durch eine geringe Oberfläche der Struktur weiter reduziert werden.

Die Eingänge 14a-d sind jeweils mit einer Induktivität 24a-d verbunden. Die Enden der Induktivitäten 24a-d sind über Brücken 40a-d mit einer ersten Platte 42 verbunden. Ein Ausgang 20 ist mit der ersten Platte 42 verbunden.

Die Multilayerleiterkarte 36 weist in der dritten elektrisch leitfähigen Lage 38c eine zweite Platte 44 auf, die der ersten Platte 42 gegenüberliegt. Die zweite Platte 44 ist mit einem Erdungsanschluss 22 verbunden. Die zweite Platte 44 steht nicht in Kontakt mit den Brücken 40a-d.

Die Multilayerleiterkarte 36 weist optional in der vierten elektrisch leitfähigen Lage 38d eine dritte Platte 46 auf, die - ebenso wie die erste Platte 42 - mit den Brücken 40a-d verbunden ist. Die dritte Platte 46 weist somit das gleiche Potential wie die erste Platte 42 auf. Die erste Platte 42, die zweite Platte 44 und die dritte Platte 46 bilden zusammen einen Combinerkondensator 26. Durch die dritte Platte 46 wird die Kapazität des Combinerkondensators 26 signifikant erhöht.

Die Durchkontaktierungen zwischen den Lagen der Multilayerleiterkarte 36 können durch alle Lagen gehen und in jeder Lage elektrisch leitfähige Pads aufweisen. Dann sind vier Pads auf der ersten Lage 38a vorhanden, die von der zweiten Ebene vom Potential des Ausgangs 20 bis zur ersten Lage 38a elektrischen Kontakt haben. Diese liegen nun sehr nah an dem Kreuzungspunkt 34. Zur sicheren Isolierung und zur Vermeidung von Kriechströmen kann eine Isolierplatte auf die erste Ebene gepresst oder geklebt werden. Diese Isolierplatte kann die Größe der dritten Platte 46 haben.

Die Anpassungsglieder 28, 28a-28d können jeweils eine Reihenschaltung von einem Kondensator und Widerstand aufweisen. Der Widerstand kann gut gekühlt werden, wenn er in einer Ausnehmung der Multilayerleiterkarte 36 angeordnet ist, sodass die Kontakte auf der Multilayerleiterkarte 36 angelötet sind und sein sich erwärmender Körper auf einer unter der Multilayerleiterkarte 36 angeordneten Kühlplatte kontaktiert ist.

Die Multilayerleiterkarte 36 kann gekühlt werden, wenn sie mittels einer Keramikplatte befestigt ist, die zwischen der Multilayerleiterkarte 36 und einer Kühlplatte an der Kühlplatte befestigt ist. Die Keramikplatte kann 2 mm bis 7 mm dick sein. Die Keramikplatte kann kleinere Abmessungen in der Fläche aufweisen als die Multilayerleiterkarte 36. Die Multilayerleiterkarte 36 kann demnach über die Keramikplatte überstehen.

Die Keramikplatte kann so ausgestaltet sein, dass sie die Induktivitäten 24a - 24d abdeckt, aber Anschlüsse 25a - d nicht abdeckt. Dann können die Anschlüsse 25a - d mit anderen Leiterkarten, beispielsweise mit den Ausgängen von den Verstärkerleiterkarten, direkt verbunden werden.

Die Keramikplatte kann so ausgestaltet sein, dass sie die Induktivitäten 24a - d abdeckt, aber die Anschlüsse des Ausgangs 20 und den Erdungsanschluss 22 nicht abdeckt. Dann können diese Anschlüsse mit anderen Leiterkarten oder mit der an die Erdung angeschlossenen Kühlplatte direkt verbunden werden.

Unter Vornahme einer Zusammenschau aller Figuren der Zeichnung betrifft die Erfindung einen Leistungscombiner 12 in Form eines ausbalancierten LC-Combiners. Eingänge 14a-d des Leistungscombiners 12 sind jeweils über zumindest ein RC-Anpassungsglied 28, 28a-d voneinander isoliert. Das zumindest eine RC-Anpassungsglied 28, 28a-d ist vorzugsweise so dimensioniert, dass die Verbindung zwischen den Eingängen 14a-d beim Betrieb des Leistungscombiners 12 an zumindest einer Stelle auf einem stabilen Potential liegt. Der Leistungscombiner 12 ist weiter bevorzugt in planarer Bauweise ausgebildet und weist parallel zueinander verlaufende elektrisch leitfähige Lagen 38a-d auf. In den elektrisch leitfähigen Lagen 38a-d sind vorzugsweise zumindest Induktivitäten 24a-d und ein Combinerkondensator 26 ausgebildet. Die Erfindung betrifft weiterhin eine Leistungscombineranordnung 10 mit einem zuvor beschriebenen Leistungscombiner 12 und an zumindest zwei Eingängen 14a-d angeschlossenen Hochfrequenzsignalquellen 16a-d, die bevorzugt in Form frequenzagiler Transistorverstärker ausgebildet sind.

leitfähige Lagen 38a-d auf. In den elektrisch leitfähigen Lagen 38a-d sind vorzugsweise zumindest Induktivitäten 24a-d und ein Combinerkondensator 26 ausgebildet. Die Erfindung betrifft weiterhin eine Leistungscombineranordnung 10 mit einem zuvor beschriebenen Leistungscombiner 12 und an zumindest zwei Eingängen 14a-d angeschlossenen Hochfrequenzsignalquellen 16a-d, die bevorzugt in Form frequenzagiler Transistorverstärker ausgebildet sind.

**Patentansprüche**

1. Leistungscombiner (12) zur Kopplung von Hochfrequenzsignalen mit einer Frequenz von mehr als 1 MHz zu einer Ausgangsleistung von mehr als 100 W, wobei der Leistungscombiner (12) Folgendes aufweist:

  a) einen ersten Eingang (14a-d) für ein erstes Hochfrequenzsignal;
  b) einen zweiten Eingang (14a-d) für ein zweites Hochfrequenzsignal;
  c) einen Ausgang (20) zum Anschluss eines Verbrauchers (18);

d) einen Erdungsanschluss (22);

e) eine erste Induktivität (24a-d), die den ersten Eingang (14a-d) mit dem Ausgang (20) verbindet;

f) eine zweite Induktivität (24a-d), die den zweiten Eingang (14a-d) mit dem Ausgang (20) verbindet;

g) einen Combinerkondensator (26), der den Ausgang (20) mit dem Erdungsanschluss (22) verbindet;

h) ein erstes RC-Anpassungsglied (28, 28a-d), das den ersten Eingang (14a-d) mit dem zweiten Eingang (14a-d) verbindet,

wobei die erste Induktivität (24a-d) magnetisch von der zweiten Induktivität (24a-d) entkoppelt ist, wobei der Leistungscombiner (12) zumindest teilweise planar durch eine Multilayerleiterkarte (36) ausgebildet ist, wobei der Leistungscombiner (12) eine erste Leiterplatte mit einer ersten elektrisch leitfähigen Lage (38a-d) und einer ersten elektrisch isolierenden Schicht aufweist, wobei die erste Leiterplatte das erste RC-Anpassungsglied (28, 28a-d) aufweist, wobei der Leistungscombiner (12) zur Kopplung von Hochfrequenzsignalen zwischen 1 MHz und 200 MHz ausgebildet ist, und wobei die Induktivitäten (24a-d) als planare Induktivitäten in parallelen Ebenen oder in der gleichen Ebene beabstandet voneinander angeordnet sind und die äußersten Windungen der Induktivitäten (24a-d) einen Abstand von wenigstens 1 cm aufweisen.

2. Leistungscombiner nach Anspruch 1, bei dem der Leistungscombiner (12) einen dritten Eingang (14a-d) für ein drittes Hochfrequenzsignal aufweist, wobei der dritte Eingang (14a-d) über eine dritte Induktivität (24a-d) des Leistungscombiners (12) mit dem Ausgang (20) verbunden ist, wobei die dritte Induktivität (24a-d) magnetisch von der ersten Induktivität (24a-d) und der zweiten Induktivität (24a-d) entkoppelt ist, wobei das erste RC-Anpassungsglied (28, 28a-d) einenends mit dem ersten Eingang (14a-d) verbunden ist, wobei ein zweites RC-Anpassungsglied (28, 28a-d) einenends mit dem zweiten Eingang (14a-d) verbunden ist und wobei ein drittes RC-Anpassungsglied (28, 28a-d) einenends mit dem dritten Eingang (14a-d) verbunden ist, wobei das erste RC-Anpassungsglied (28, 28a-d), das zweite RC-Anpassungsglied (28, 28a-d) und das dritte RC-Anpassungsglied (28, 28a-d) anderenends miteinander verbunden sind.

3. Leistungscombiner nach Anspruch 2, bei dem der Leistungscombiner (12) einen weiteren Eingang (14a-d) für ein weiteres Hochfrequenzsignal aufweist, wobei der weitere Eingang (14a-d) über eine weitere Induktivität (24a-d) des Leistungscombiners (12) mit dem Ausgang (20) verbunden ist, wobei die weitere Induktivität (24a-d) magnetisch von der ersten Induktivität (24a-d), der zweiten Induktivität (24a-d) und der dritten Induktivität (24a-d) entkoppelt ist und wobei ein weiteres RC-Anpassungsglied (28, 28a-d) einenends mit dem weiteren Eingang (14a-d) und anderenends mit dem ersten RC-Anpassungsglied (28, 28a-d), dem zweiten RC-Anpassungsglied (28, 28a-d) und dem dritten RC-Anpassungsglied (28, 28a-d) verbunden ist.

4. Leistungscombiner nach Anspruch 1, bei dem das erste RC-Anpassungsglied (28, 28a-d) eine Reihenschaltung aus einem Anpassungswiderstand (30) und einem Anpassungskondensator (32, 32a-b) aufweist.

5. Leistungscombiner nach Anspruch 2 oder 3, bei dem alle RC-Anpassungsglieder (28, 28a-d) eine Reihenschaltung aus einem Anpassungswiderstand (30) und einem Anpassungskondensator (32, 32a-b) aufweisen.

6. Leistungscombiner nach einem der vorhergehenden Ansprüche , bei dem ein Anpassungswiderstand (30) und ein Anpassungskondensator (32, 32a-b) eines RC-Anpassungsgliedes (28, 28a-d) jeweils in Bauteilform auf die erste Leiterplatte bestückt sind.

7. Leistungscombiner nach einem der vorhergehenden Ansprüche, bei dem die erste Leiterplatte den ersten Eingang (14a-d) und den zweiten Eingang (14a-d) aufweist.

8. Leistungscombiner nach einem der vorhergehenden Ansprüche, bei dem der Combinerkondensator (26) in Form eines Plattenkondensators ausgebildet ist, wobei eine erste Platte (42) des Plattenkondensators auf einer zweiten elektrisch leitfähigen Lage (38a-d) der Multilayerleiterkarte (36) und eine zweite Platte (44) des Plattenkondensators auf einer dritten elektrisch leitfähigen Lage (38a-d) der Multilayerleiterkarte (36) ausgebildet sind.

9. Leistungscombiner nach Anspruch 8, bei dem der Plattenkondensator eine dritte Platte (46) aufweist, die mit der ersten Platte (42) verbunden ist und auf einer vierten elektrisch leitfähigen Lage (38a-d) der Multilayerleiterkarte (36) ausgebildet ist.

10. Leistungscombiner nach Anspruch 9, bei dem die zweite Platte (44) zwischen der ersten Platte (42) und der dritten Platte (46) angeordnet ist.

**11.** Leistungscombiner nach einem der vorhergehenden Ansprüche 8 bis 10, bei dem die zweite elektrisch leitfähige Lage (38a-d) die erste Induktivität (24a-d) in Form einer planar ausgebildeten Induktivität aufweist.

**12.** Leistungscombiner nach einem der vorhergehenden Ansprüche, wobei der Erdungsanschluss (22) mit einer Kühlplatte des Leistungscombiners (12) verbindbar ist.

**13.** Leistungscombiner nach einem der vorhergehenden Ansprüche, ausgebildet zur Kopplung von Leistungen über 2 kW.

**14.** Leistungscombineranordnung (10) mit einem Leistungscombiner (12) nach einem der vorhergehenden Ansprüche, wobei die Leistungscombineranordnung (10) eine erste Hochfrequenzsignalquelle (16a-d), die an den ersten Eingang (14a-d) angeschlossen ist und eine zweite Hochfrequenzsignalquelle (16a-d), die an den zweiten Eingang (14a-d) angeschlossen ist, aufweist.

**15.** Leistungscombineranordnung nach Anspruch 14, bei der die Impedanz der RC-Anpassungsglieder (28, 28a-d) so gewählt ist, dass die Gesamtimpedanz zwischen zwei Eingängen (14a-d) der Summe der Ausgangsimpedanzen der Hochfrequenzsignalquellen (16a-d) an diesen beiden Eingängen (14a-d) entspricht.

**Claims**

**1.** Power combiner (12) for coupling high-frequency signals having a frequency of more than 1 MHz to an output power of more than 100 W, wherein the power combiner (12) has the following:

     a) a first input (14a-d) for a first high-frequency signal;
     b) a second input (14a-d) for a second high-frequency signal;
     c) an output (20) for connecting a consumer (18);
     d) an earth terminal (22);
     e) a first inductor (24a-d) connecting the first input (14a-d) to the output (20);
     f) a second inductor (24a-d) connecting the second input (14a-d) to the output (20);
     g) a combiner capacitor (26) connecting the output (20) to the earth terminal (22);
     h) a first RC adapter (28, 28a-d) connecting the first input (14a-d) to the second input (14a-d), wherein the first inductor (24a-d) is magnetically decoupled from the second inductor (24a- d), wherein the power combiner (12) is formed at least in part in a planar manner by a multilayer circuit board (36), wherein the power combiner (12) has a first printed circuit board having a first electrically conductive layer (38a-d) and a first electrically insulating layer, wherein the first printed circuit board has the first RC adapter (28, 28a-d), wherein the power combiner (12) is designed for coupling high-frequency signals between 1 MHz and 200 MHz, and wherein the inductors (24a-d) are arranged as planar inductors at a spacing from one another either in parallel planes or in the same plane and the outermost windings of the inductors (24a-d) are spaced apart by at least 1 cm.

**2.** Power combiner according to claim 1, in which the power combiner (12) has a third input (14a-d) for a third high-frequency signal, wherein the third input (14a-d) is connected to the output (20) via a third inductor (24a-d) of the power combiner (12), wherein the third inductor (24a-d) is magnetically decoupled from the first inductor (24a-d) and the second inductor (24a-d), wherein the first RC adapter (28, 28a-d) is connected at one end to the first input (14a-d), wherein a second RC adapter (28, 28a-d) is connected at one end to the second input (14a-d) and wherein a third RC adapter (28, 28a-d) is connected at one end to the third input (14a-d), wherein the first RC adapter (28, 28a-d), the second RC adapter (28, 28a-d) and the third RC adapter (28, 28a-d) are connected to one another at the other end.

**3.** Power combiner according to claim 2, in which the power combiner (12) has a further input (14a-d) for a further high-frequency signal, wherein the further input (14a-d) is connected to the output (20) via a further inductor (24a-d) of the power combiner (12), wherein the further inductor (24a-d) is magnetically decoupled from the first inductor (24a-d), the second inductor (24a-d) and the third inductor (24a-d) and wherein a further RC adapter (28, 28a -d) is connected at one end to the further input (14a-d) and at the other end to the first RC adapter (28, 28a-d), the second RC adapter (28, 28a-d) and the third RC adapter (28, 28a-d).

**4.** Power combiner according to claim 1, in which the first RC adapter (28, 28a-d) has a series circuit formed of a matching resistor (30) and a matching capacitor (32, 32a-b).

5. Power combiner according to claim 2 or 3, in which all RC adapters (28, 28a-d) have a series circuit formed of a matching resistor (30) and a matching capacitor (32, 32a-b).

6. Power combiner according to one of the preceding claims, in which a matching resistor (30) and a matching capacitor (32, 32a-b) of an RC adapter (28, 28a-d) are each fitted on the first printed circuit board in component form.

7. Power combiner according to one of the preceding claims, in which the first circuit board has the first input (14a-d) and the second input (14a-d).

8. Power combiner according to one of the preceding claims, in which the combiner capacitor (26) is designed in the form of a plate capacitor, wherein a first plate (42) of the plate capacitor is arranged on a second electrically conductive layer (38a-d) of the multilayer circuit board (36) and a second plate (44) of the plate capacitor is arranged on a third electrically conductive layer (38a-d) of the multilayer circuit board (36).

9. Power combiner according to claim 8, in which the plate capacitor has a third plate (46) which is connected to the first plate (42) and formed on a fourth electrically conductive layer (38a-d) of the multilayer circuit board (36).

10. Power combiner according to claim 9, wherein the second plate (44) is arranged between the first plate (42) and the third plate (46).

11. Power combiner according to one of the preceding claims 8 to 10, in which the second electrically conductive layer (38a-d) has the first inductor (24a-d) in the form of a planar inductor.

12. Power combiner according to one of the preceding claims, wherein the earth connection (22) can be connected to a cooling plate of the power combiner (12).

13. Power combiner according to one of the preceding claims, designed for coupling powers over 2 kW.

14. Power combiner arrangement (10) comprising a power combiner (12) according to one of the preceding claims, wherein the power combiner arrangement (10) has a first high-frequency signal source (16a-d), which is connected to the first input (14a-d), and a second high-frequency signal source (16a- d), which is connected to the second input (14a-d).

15. Power combiner arrangement according to claim 14, in which the impedance of the RC adapters (28, 28a-d) is selected such that the total impedance between two inputs (14a-d) corresponds to the total of the output impedances of the high-frequency sources (16a-d) at these two inputs (14a-d).

**Revendications**

1. Coupleur de puissance (12) pour coupler des signaux haute fréquence d'une fréquence supérieure à 1 MHz avec une puissance de sortie supérieure à 100 W, ledit coupleur de puissance (12) comprenant :

   a) une première entrée (14a-d) pour un premier signal haute fréquence ;
   b) une deuxième entrée (14a-d) pour un deuxième signal haute fréquence ;
   c) une sortie (20) pour connecter un consommateur (18) ;
   d) une prise de terre (22) ;
   e) une première inductance (24a-d), laquelle connecte la première entrée (14a-d) à la sortie (20) ;
   f) une deuxième inductance (24a-d), laquelle connecte la deuxième entrée (14a-d) à la sortie (20) ;
   g) un condensateur coupleur (26), lequel connecte la sortie (20) à la prise de terre (22) ;
   h) un premier adaptateur RC (28, 28a-d), lequel connecte la première entrée (14a-d) à la deuxième entrée (14a-d), la première inductance (24a-d) étant découplée de manière magnétique de la deuxième inductance (24a- d), le coupleur de puissance (12) étant au moins partiellement de conception planaire au moyen d'une carte multicouche de circuits imprimés (36), le coupleur de puissance (12) comportant une première carte de circuits imprimés dotée d'une première couche (38a-d) électriquement conductrice et d'une première couche électriquement isolante, la première carte de circuits imprimés comportant le premier adaptateur RC (28, 28ad), le coupleur de puissance (12) étant conçu pour coupler des signaux haute fréquence dans la plage comprise entre 1 MHz et 200 MHz, les inductances (24a-d), en tant qu'inductances planaires, étant disposées à distance les unes des autres dans des plans parallèles ou dans le même plan et les spires les plus à l'extérieur des inductances (24a-d) présentant une distance d'au moins 1 cm.

2. Coupleur de puissance selon la revendication 1, dans lequel
ledit coupleur de puissance (12) comporte une troisième entrée (14a-d) pour un troisième signal haute fréquence, ladite troisième entrée (14a-d) étant connectée à la sortie (20) par l'intermédiaire d'une troisième inductance (24a-d) du coupleur de puissance (12), la troisième inductance (24a-d) étant découplée de manière magnétique de la première inductance (24a-d) et de la deuxième inductance (24a-d), le premier adaptateur RC (28, 28a-d) étant connecté à la première entrée (14a-d) par l'intermédiaire d'une extrémité, un deuxième adaptateur RC (28, 28a-d) étant connecté à la deuxième entrée (14a-d) par l'intermédiaire d'une extrémité et un troisième adaptateur RC (28, 28a-d) étant connecté à la troisième entrée (14a-d) par l'intermédiaire d'une extrémité, le premier adaptateur RC (28, 28a-d), le deuxième adaptateur RC (28, 28a-d) et le troisième adaptateur RC (28, 28a-d) étant connectés à l'autre extrémité.

3. Coupleur de puissance selon la revendication 2, dans lequel
ledit coupleur de puissance (12) comporte une autre entrée (14a-d) pour un autre signal haute fréquence, l'autre entrée (14a-d) étant connectée à la sortie (20) par l'intermédiaire d'une autre inductance (24a-d) du coupleur de puissance (12), l'autre inductance (24a-d) étant découplée de manière magnétique de la première inductance (24a-d), de la deuxième inductance (24a-d) et de la troisième inductance (24a-d) et un autre adaptateur RC (28, 28a-d) étant connecté par l'intermédiaire d'une extrémité à l'autre entrée (14a-d) et par l'intermédiaire de l'autre extrémité au premier adaptateur RC (28, 28a-d), au deuxième adaptateur RC (28, 28a-d) et au troisième adaptateur RC (28, 28a-d).

4. Coupleur de puissance selon la revendication 1, dans lequel le premier adaptateur RC (28, 28a-d) comporte un circuit série comprenant une résistance d'adaptation (30) et un condensateur d'adaptation (32, 32a-b).

5. Coupleur de puissance selon la revendication 2 ou 3, dans lequel tous les adaptateurs RC (28, 28a-d) comportent un circuit série comprenant une résistance d'adaptation (30) et un condensateur d'adaptation (32, 32a-b).

6. Coupleur de puissance selon l'une quelconque des revendications précédentes, dans lequel une résistance d'adaptation (30) et un condensateur d'adaptation (32, 32a-b) d'un adaptateur RC (28, 28a-d) sont respectivement montés sous forme de composants sur la première carte de circuits imprimés.

7. Coupleur de puissance selon l'une quelconque des revendications précédentes, dans lequel la première carte de circuits imprimés comporte la première entrée (14a-d) et la deuxième entrée (14a-d).

8. Coupleur de puissance selon l'une quelconque des revendications précédentes, dans lequel le condensateur coupleur (26) est conçu sous forme d'un condensateur à plaques, dans lequel une première plaque (42) du condensateur à plaques est formée sur une deuxième couche électriquement conductrice (38a-d) de la carte multicouche de circuits imprimés (36) et une deuxième plaque (44) du condensateur à plaques est formée sur une troisième couche électriquement conductrice (38a-d) de la carte multicouche de circuits imprimés (36).

9. Coupleur de puissance selon la revendication 8, dans lequel le condensateur à plaques comporte une troisième plaque (46) reliée à la première plaque (42) et formée sur une quatrième couche électriquement conductrice (38a-d) de la carte multicouche de circuits imprimés (36).

10. Coupleur de puissance selon la revendication 9, dans lequel la deuxième plaque (44) est disposée entre la première plaque (42) et la troisième plaque (46).

11. Coupleur de puissance selon l'une quelconque des revendications précédentes 8 à 10, dans lequel la deuxième couche électriquement conductrice (38a-d) comporte la première inductance (24a-d) sous forme d'une inductance planaire.

12. Coupleur de puissance selon l'une quelconque des revendications précédentes, dans lequel la prise de terre (22) peut être connectée à une plaque de refroidissement du coupleur de puissance (12).

**13.** Coupleur de puissance selon l'une quelconque des revendications précédentes, conçu pour coupler des puissances supérieures à 2 kW.

**14.** Ensemble coupleur de puissance (10) comprenant un coupleur de puissance (12) selon l'une quelconque des revendications précédentes, dans lequel ledit ensemble coupleur de puissance (10) comporte une première source de signal haute fréquence (16a-d), laquelle est connectée à la première entrée (14a-d) et une seconde source de signal haute fréquence (16a- d), laquelle est connectée à la deuxième entrée (14a-d).

**15.** Ensemble coupleur de puissance selon la revendication 14, dans lequel l'impédance des adaptateurs RC (28, 28a-d) est sélectionnée de telle sorte que l'impédance totale entre deux entrées (14a-d) correspond à la somme des impédances de sortie des sources de signaux haute fréquence (16a-d) à ces deux entrées (14a-d).

Fig. 1

Fig. 2

Fig. 3

Fig. 4

**IN DER BESCHREIBUNG AUFGEFÜHRTE DOKUMENTE**

**In der Beschreibung aufgeführte Patentdokumente**

- EP 0210606 A2
- DE 2733888 A1
- US 20140292441 A1
- EP 1347532 A1

**In der Beschreibung aufgeführte Nicht-Patentliteratur**

- An extremely miniaturized ultra wide band 10-67 GHz Power Splitter in 65 nm CMOS Technology. **ERCOLI M. et al.** microwave symposium digest (MTT), 2012 IEEE MTT-S international. IEEE, 17. Juni 2012, 1-3
- Miniature Four-Way and Two-Way 24 GHz Wilkinson Power Dividers in 0.13 m CMOS. **JEONG-GEUN KIM et al.** IEEE microwave and wireless components letters. IEEE service center, 01. September 2007, vol. 17, 658-660
- A lumped element power divider/combiner suitable for high power applications. **SEYED MAJID MOHA-MADI DEMNEH et al.** microwave and millimeter wave technology (ICMMT), 2012 international conference on. IEEE, 05. Mai 2012, 1-4